# EUROPEAN PATENT SPECIFICATION

(11) **EP 4 167 344 B1**
(45) Date of publication and mention of the grant of the patent: **25.11.2026**
(21) Application number: 21856137.1
(22) Date of filing: 05.08.2021
(51) Int. Cl.: H02J 7/96, G01R 31/3835, B60L 53/62, H01M 10/42, H01M 10/44

(54) **BATTERY MANAGEMENT SYSTEM, BATTERY MANAGEMENT METHOD, BATTERY PACK AND ELECTRIC VEHICLE**
BATTERIEVERWALTUNGSSYSTEM, BATTERIEVERWALTUNGSVERFAHREN, BATTERIEPACK UND ELEKTROFAHRZEUG
SYSTÈME DE GESTION DE BATTERIE, PROCÉDÉ DE GESTION DE BATTERIE, BLOC-BATTERIE ET VÉHICULE ÉLECTRIQUE

(30) Priority: 13.08.2020 KR 20200101934
(43) Date of publication of application: 19.04.2023
(60) Divisional application: 26162310.2 / 4 725 752
(73) Proprietor: LG Energy Solution, Ltd., Seoul 07335 (KR)
(72) Inventor: NAM, Gi-Min, Daejeon 34122 (KR); KIM, Hyeong-Seok, Daejeon 34122 (KR); PARK, Eun-Yong, Daejeon 34122 (KR); CHOI, Ji-Hyun, Daejeon 34122 (KR); JOE, Won-Tae, Daejeon 34122 (KR); OH, Song-Taek, Daejeon 34122 (KR)
(74) Representative: Hoffmann Eitle
(86) International application number: PCT/KR2021/010343
(87) International publication number: WO 2022/035131

(56) References cited:
- WO-A1-2020/130324
- CN-A- 102 474 124
- JP-B2- 4 689 768
- JP-B2- 4 805 863
- KR-A- 20170 022 778
- KR-B1- 101 680 324
- US-A1- 2012 169 284
- US-A1- 2018 145 531
- US-A1- 2019 363 546
- US-A1- 20240 136 844

## Description

### TECHNICAL FIELD

The present disclosure relates to battery charge control.

### BACKGROUND ART

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that can be charged and discharged repeatedly.

Currently, commercially available batteries include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

In the constant current charging of a battery, when the current rate of the charge current is low, it takes a very long time to fully charge the battery. In contrast, when the current rate of the charge current is too high, the battery degrades fast.

One of charge protocols proposed to solve this problem is 'multi-stage constant-current charging', namely, stepwise adjustment of the current rate of the charge current according to the State Of Charge (SOC) or voltage of the battery during charging. The current rate is a value obtained by dividing the charge current by the maximum capacity of the battery, and may be referred to as 'C-rate', and it's unit is 'C'. A multi-stage constant-current charge map includes at least one data array recording a correlation between a plurality of C-rates and a plurality of SOC ranges. A charging procedure using the multi-stage constant-current charge map includes repeating the process of supplying the charge current of the next C-rate to the battery each time the SOC of the battery reaches the upper limit value of each SOC range.

As the battery degrades from Beginning Of Life (BOL), degradation by the same C-rate may be accelerated. However, the charging procedure using the conventional multi-stage constant-current charge map does not consider the degradation of the battery.

US 2024/0136844 A1 discloses an apparatus and method for controlling step charging of a secondary battery. A charging control unit determines a SOC, an OCV and a polarization voltage of the secondary battery, determines an OCV deviation corresponding to a difference between the OCV and a predefined minimum OCV value, determines a correction factor corresponding to the polarization voltage and the OCV deviation, determines a look-up SOC by correcting the SOC according to the correction factor, determines the magnitude of a charging current corresponding to the look-up SOC, and provides the determined charging current to a charging device.

US 2012/0169284 A1 discloses a battery charging method, and a battery pack using the same. In the battery charging method, constant-current charging is performed in a plurality of phases, and a magnitude of charge current with which a battery is charged is determined according to a charge amount of the battery. The charge amount may be determined by measuring the voltage of the battery or by integrating the charging current over time. When the battery charging method is used, a battery charging time is reduced and the battery is less apt to be overcharged.

US 2019/0363546 A1 discloses a charging control device. The charging control device is equipped with a state of charge detection unit adapted to detect a state of charge of a secondary battery, a storage unit adapted to store a charging pattern in which the state of charge and a charging current are associated, and a charging control unit adapted to change the charging pattern in accordance with the state of charge of the secondary battery when charging is initiated, and to control the charging current in accordance with the charging pattern after having been changed.

US 2018/0145531 A1 discloses a battery charging method, a battery charging information generating method, and a battery charging apparatus. The battery charging apparatus may measure a temperature of a battery, may estimate a state of charge (SOC) and a state of health (SOH) of the battery, may acquire an F mapping relationship that maps F values to C-rates and SOCs at the temperature and the SOH, the F value denoting a ratio of variation of SOC to variation of voltage, and may generate a charging profile that is a sequence of charging C-rates for each of the SOCs for charging the battery based on the estimated SOC and the F mapping relationship

### DISCLOSURE

### Technical Problem

The present disclosure is designed to solve the above-described problem, and therefore the present disclosure is directed to providing a battery management system, a battery management method, a battery pack and an electric vehicle, in which a multi-stage constant-current charge map is updated based on battery voltage and battery current monitored during charging using the multi-stage constant-current charge map.

The present disclosure is further directed to providing a battery management system, a battery management method, a battery pack and an electric vehicle, in which even though the charging procedure ends after it is performed on only some of a plurality of State Of Charge (SOC) ranges, the C-rate of each of the remaining SOC ranges is updated based on the C-rate update results of the SOC ranges having undergone the charging procedure.

These and other objects and advantages of the present disclosure may be understood by the following description and will be apparent from the embodiments of the present disclosure. In addition, it will be readily understood that the objects and advantages of the present disclosure may be realized by the means set forth in the appended claims and a combination thereof.

### Technical Solution

A battery management system according to an aspect of the present disclosure includes a sensing unit configured to generate a sensing signal indicating a battery voltage and a battery current of a battery, a memory unit configured to store a charge map recording a correlation between first to n^{th} reference state of charge (SOC) ranges, first to n^{th} reference currents and first to n^{th} reference voltages for multi-stage constant-current charging, and a control unit configured to start constant current charging using a k^{th} reference current corresponding to a k^{th} reference SOC range to which an SOC of the battery belongs among the first to n^{th} reference SOC ranges in response to a charge start command. The control unit is configured to change from the constant current charging to constant voltage charging using a k^{th} reference voltage in response to the battery voltage having reached the k^{th} reference voltage corresponding to the k^{th} reference SOC range before the SOC of the battery reaches an upper limit value of the k^{th} reference SOC range during the constant current charging. The control unit is configured to update the k^{th} reference current of the charge map based on a time-series of the battery current in a charging period of the constant voltage charging in response to the SOC of the battery having reached the upper limit value of the k^{th} reference SOC range during the constant voltage charging. n is a natural number of 2 or greater, and k is a natural number of n or smaller.

The control unit may be configured to determine an average current in the charging period from the time-series of the battery current. The control unit may be configured to update the k^{th} reference current to be equal to the average current.

The control unit may be configured to determine an average current in the charging period from the time-series of the battery current. The control unit may be configured to update the k^{th} reference current to be equal to a sum of multiplication of the k^{th} reference current and a first weight and multiplication of the average current and a second weight.

Each of the first weight and the second weight may be a positive number of less than 1, and a sum of the first weight and the second weight may be 1.

The control unit may be configured to update each remaining reference current except the k^{th} reference current among the first to n^{th} reference currents based on a ratio of the updated k^{th} reference current to the k^{th} reference current.

A battery pack according to another aspect of the present disclosure includes the battery management system.

An electric vehicle according to still another aspect of the present disclosure includes the battery pack.

A battery management method according to yet another aspect of the present disclosure includes starting constant current charging using a k^{th} reference current corresponding to a k^{th} reference state of charge (SOC) range to which an SOC of the battery belongs among first to n^{th} reference SOC ranges from a charge map recording a correlation between the first to n^{th} reference SOC ranges, first to n^{th} reference currents and first to n^{th} reference voltages for multi-stage constant-current charging in response to a charge start command, changing from the constant current charging to constant voltage charging using a k^{th} reference voltage in response to a battery voltage having reached the k^{th} reference voltage corresponding to the k^{th} reference SOC range before the SOC of the battery reaches an upper limit value of the k^{th} reference SOC range during the constant current charging, and updating the charge map based on a time-series of a battery current in a charging period of the constant voltage charging in response to the SOC of the battery having reached the upper limit value of the k^{th} reference SOC range during the constant voltage charging. n is a natural number of 2 or greater, and k is a natural number of n or smaller.

Updating the k^{th} reference current of the charge map may include determining an average current over the charging period from the time-series of the battery current, and updating the k^{th} reference current to be equal to the average current.

The battery management method may further include updating each remaining reference current except the k^{th} reference current among the first to n^{th} reference currents based on a ratio between the k^{th} reference current and the updated k^{th} reference current.

### Advantageous Effects

According to at least one of the embodiments of the present disclosure, it is possible to update a multi-stage constant-current charge map based on battery voltage and battery current monitored during charging using the multi-stage constant-current charge map.

Additionally, according to at least one of the embodiments of the present disclosure, even though the charging procedure ends after it is performed on only some of a plurality of State Of Charge (SOC) ranges, the C-rate of each of the remaining SOC ranges may be updated based on the C-rate update results of the SOC ranges having undergone the charging procedure.

The effects of the present disclosure are not limited to the effects mentioned above, and these and other effects will be clearly understood by those skilled in the art from the appended claims.

### DESCRIPTION OF DRAWINGS

The accompanying drawings illustrate a preferred embodiment of the present disclosure, and together with the detailed description of the present disclosure described below, serve to provide a further understanding of the technical aspects of the present disclosure, and thus the present disclosure should not be construed as being limited to the drawings.
FIG. 1 is a diagram exemplarily showing a configuration of an electric vehicle according to the present disclosure.
FIG. 2 is a diagram exemplarily showing a correlation between a reference state of charge (SOC) range and a reference current recorded in a charge map.
FIG. 3 is a diagram exemplarily showing a correlation between a reference SOC range and a reference voltage recorded in a charge map.
FIG. 4 is a flowchart exemplarily showing a battery management method according to a first embodiment of the present disclosure.
FIG. 5 is a flowchart exemplarily showing a battery management method according to a second embodiment of the present disclosure.

### BEST MODE

Hereinafter, the preferred embodiments of the present disclosure will be described in detail with reference to the accompanying drawings. Prior to the description, it should be understood that the terms or words used in the specification and the appended claims should not be construed as being limited to general and dictionary meanings, but rather interpreted based on the meanings and concepts corresponding to the technical aspects of the present disclosure on the basis of the principle that the inventor is allowed to define the terms appropriately for the best explanation.

Therefore, the embodiments described herein and illustrations shown in the drawings are just a most preferred embodiment of the present disclosure, but not intended to fully describe the technical aspects of the present disclosure, so it should be understood that a variety of other equivalents and modifications could have been made thereto at the time that the application was filed.

The terms including the ordinal number such as "first", "second" and the like, are used to distinguish one element from another among various elements, but not intended to limit the elements by the terms.

Unless the context clearly indicates otherwise, it will be understood that the term "comprises" when used in this specification, specifies the presence of stated elements, but does not preclude the presence or addition of one or more other elements. Additionally, the term "control unit" refers to a processing unit of at least one function or operation, and this may be implemented by hardware and software either alone or in combination.

In addition, throughout the specification, it will be further understood that when an element is referred to as being "connected to" another element, it can be directly connected to the other element or intervening elements may be present.

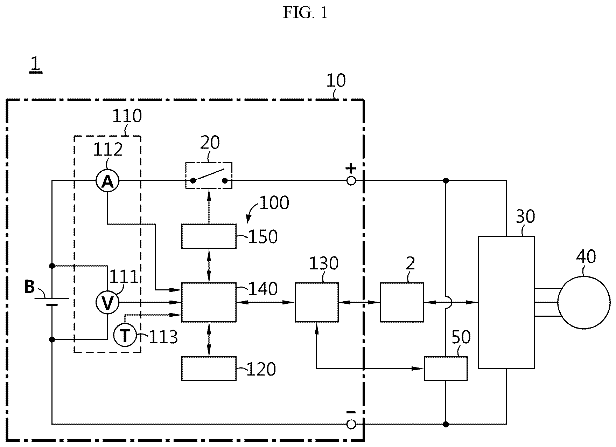

FIG. 1 is a diagram exemplarily showing a configuration of an electric vehicle according to the present disclosure.

Referring to FIG. 1, the electric vehicle 1 includes a battery pack 10, an inverter 30, an electric motor 40 and a charging circuit 50.

The battery pack 10 includes a battery B, a switch 20 and a battery management system 100.

The battery B includes at least one battery cell. Each battery cell is not limited to a particular type, and may include any battery cell that can be repeatedly recharged such as, for example, a lithium ion cell. The battery B may be coupled to the inverter 30 and/or the charging circuit 50 through a pair of power terminals provided in the battery pack 10.

The switch 20 is connected in series to the battery B. The switch 20 is installed on a current path for the charge/discharge of the battery B. The on/off of the switch 20 is controlled in response to a switching signal from the battery management system 100. The switch 20 may be a mechanical relay that is turned on/off by the electromagnetic force of a coil or a semiconductor switch such as a Metal Oxide Semiconductor Field Effect transistor (MOSFET).

The inverter 30 is provided to convert the direct current (DC) from the battery B to alternating current (AC) in response to a command from the battery management system 100. The electric motor 40 may be, for example, a three-phase AC motor. The electric motor 40 works using the AC power from the inverter 30.

The battery management system 100 may be responsible for the general control related to the charge/discharge of the battery B. The battery management system 100 includes a sensing unit 110, a memory unit 120 and a control unit 140. The battery management system 100 may further include at least one of an interface unit 130 or a switch driver 150.

The sensing unit 110 includes a voltage sensor 111 and a current sensor 112. The sensing unit 110 may further include a temperature sensor 113.

The voltage sensor 111 is connected in parallel to the battery B and configured to detect a battery voltage across the battery B and generate a voltage signal indicating the detected battery voltage. The current sensor 112 is connected in series to the battery B through the current path. The current sensor 112 is configured to detect a battery current flowing through the battery B and generate a current signal indicating the detected battery current. The temperature sensor 113 is configured to detect a temperature of the battery B and generate a temperature signal indicating the detected temperature.

The memory unit 120 may include at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory unit 120 may store data and programs required for the computation operation by the control unit 140. The memory unit 120 may store data indicating the result of the computation operation by the control unit 140.

The memory unit 120 stores a charge map. The charge map may be pre-stored in the memory unit 120 before the battery management system 100 is loaded, or may be received from, for example, a battery manufacturer or the like, or a high-level controller 2 through the interface unit 130.

The charge map is used in the charging procedure for multi-stage constant-current charging of the battery B. The charge map stores a correlation between first to n^{th} reference SOC ranges, first to n^{th} reference currents and first to n^{th} reference voltages for multi-stage constant-current charging. n is a natural number 2 or greater. The earlier reference current may be smaller than the later reference current.

The interface unit 130 may include a communication circuit configured to support wired or wireless communication between the control unit 140 and the high-level controller 2 (for example, Electronic Control Unit (ECU)). The wired communication may be, for example, controller area network (CAN) communication, and the wireless communication may be, for example, Zigbee or Bluetooth communication. The communication protocol is not limited to a particular type, and may include any communication protocol that supports the wired/wireless communication between the control unit 140 and the high-level controller 2. The interface unit 130 may include an output device (for example, a display, a speaker) to provide the information received from the control unit 140 and/or the high-level controller 2 in a recognizable format. The high-level controller 2 may control the inverter 30 based on battery information (for example, voltage, current, temperature, SOC) collected through the communication with the battery management system 100.

The control unit 140 may be operably coupled to the high-level controller 2, the switch 20, the charging circuit 50, the sensing unit 110, the memory unit 120, the interface unit 130 and/or the switch driver 150. Operably coupled refers to directly/indirectly connected to transmit and receive a signal in one or two directions.

The switch driver 150 is electrically coupled to the control unit 140 and the switch SW. the switch driver 150 is configured to selectively turn on/off the switch SW in response to a command from the control unit 140. The control unit 140 may command the switch driver 150 to turn on the switch SW during the charging procedure.

The control unit 140 may collect a sensing signal from the sensing unit 110. The sensing signal indicates the detected voltage signal, the detected current signal and/or the detected temperature signal in synchronization.

The control unit 140 may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing the other functions.

The interface unit 130 may relay the bi-directional communication between the control unit 140 and the charging circuit 50 and the bi-directional communication between the control unit 140 and the high-level controller 2. The charging circuit 50 is configured to supply a charge current of a C-rate requested from the battery management system 100 to the battery B. The charging circuit 50 may be configured to supply a charge voltage having a voltage level requested from the battery management system 100 to the battery B. The control unit 140 is configured to start the charging procedure using the charge map in response to receiving a charge start command through the interface unit 130. The control unit 140 may terminate the charging procedure using the charge map in response to receiving a charge stop command through the interface unit 130.

The control unit 140 may be determine the SOC of the battery B based on the sensing signal. In determining the SOC, a well-known algorithm such as an open circuit voltage (OCV)-SOC curve, ampere counting, Kalman filter may be used.

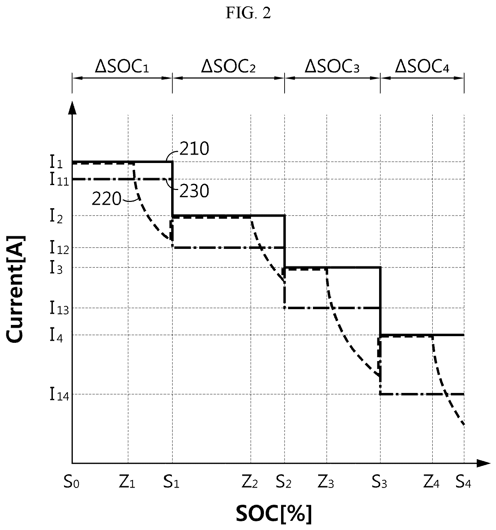

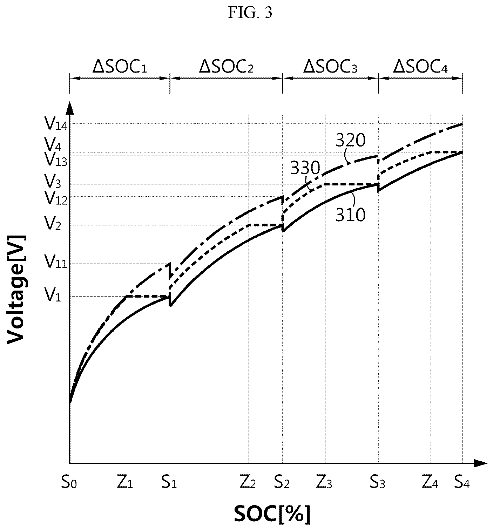

FIG. 2 is a diagram exemplarily showing the correlation between the reference SOC range and the reference current recorded in the charge map, and FIG. 3 is a diagram exemplarily showing the correlation between the reference SOC range and the reference voltage recorded in the charge map. For convenience of description, FIGS. 2 and 3 show n=4, i.e., the charge map defines the correlation between four reference SOC ranges, four reference currents and four reference voltages.

A first current profile 210 shown in FIG. 2 indicates the correlation between the first to fourth reference SOC ranges ΔOC₁~ΔSOC₄ and the first to fourth reference currents I₁~I₄ for the battery B at Beginning Of Life (BOL). The first current profile 210 may be recorded in the charge map in the format of a data table. When k is a natural number of n or smaller, Sₖ is the upper limit value of the k^{th} reference SOC range ΔSOCₖ. When m is a natural number of less than n, Sₘ is equal to the lower limit value of the m+1^{th} reference SOC range ΔSOCₘ₊₁. For example, S₁ is the lower limit value of the second reference SOC range ΔSOC₂ having S₂ as the upper limit value. The lower limit value S₀ of the first reference SOC range ΔSOC₁ may be 0 [%].

When the SOC of the battery B is in the m^{th} reference SOC range ΔSOCₘ, the control unit 140 may command constant current charging using the m^{th} reference current Iₘ to the charging circuit 50.

During constant current charging using the m^{th} reference current Iₘ, when the SOC of the battery B reaches the upper limit value Sₘ of the m^{th} reference SOC range ΔSOCₘ, the control unit 140 may command constant current charging using the m+1^{th} reference current Iₘ₊₁ to the charging circuit 50.

During constant current charging using the n^{th} reference current Iₙ, when the SOC of the battery B reaches the upper limit value Sₙ of the n^{th} reference SOC range ΔSOCₙ, the control unit 140 may command constant voltage charging to the charging circuit 50. Accordingly, the multi-stage constant-current charging using the charge map may end and be changed to constant voltage charging.

A first voltage profile 310 shown in FIG. 3 shows the correlation between the first to fourth reference SOC ranges ΔOC₁~ΔSOC₄ and the first to fourth reference voltages V₁~V₄ for the battery B at BOL. The first voltage profile 310 may be recorded in the charge map in the format of a data table. Vₖ is preset as the reference voltage indicating the battery voltage when the SOC of the battery B at BOL reaches the upper limit value Sₖ of the k^{th} reference SOC range ΔSOCₖby the k^{th} reference current Iₖ.

Meanwhile, as described above, as the battery B gradually degrades, the voltage rise by the same magnitude of charge current gets faster compared to when the battery B is at BOL. Accordingly, the battery voltage having reached the k^{th} reference voltage Vₖ during constant current charging using the k^{th} reference current Iₖ of the charge map indicates that the battery B degraded compared to when the battery B is at BOL A second voltage profile 320 shown in FIG. 3 indicates a change in battery voltage monitored through the constant current charging process of the degraded battery B using the first to fourth reference currents I₁~I₄ in a sequential order for each of the first to fourth reference SOC ranges ΔSOC₁~ΔSOC₄. Referring to the second voltage profile 320, V₁ₖ is the battery voltage when the SOC of the degraded battery B reaches the upper limit value Sₖ of the k^{th} reference SOC range ΔSOCₖ, and is found larger than the k^{th} reference voltage Vₖ. That is, V₁₁ > V₁, V₁₂ > V₂, V₁₃ > V₃, V₁₄ > V₄.

Since the k^{th} reference voltage Vₖ is the maximum allowable voltage for constant current charging using the k^{th} reference current Iₖ, as the battery voltage is higher than the k^{th} reference voltage Vₖ in the k^{th} reference SOC range ΔSOCₖ, the degradation of the battery B may be accelerated. Accordingly, during constant current charging using the k^{th} reference current Iₖ, when the battery voltage reaches the k^{th} reference voltage Vₖ, it is necessary to adjust the magnitude of the charge current below the k^{th} reference current Iₖ to suppress the degradation of the battery B.

A second current profile 220 shown in FIG. 2 and a third voltage profile 330 shown in FIG. 3 exemplarily show a time-series, i.e., time-dependent change history of the battery current and the battery voltage monitored through the process of charging the degraded battery B during charging by applying the battery management method according to the present disclosure, respectively.

Referring to the third voltage profile 330, the control unit 140 monitors the battery voltage, the battery current and the battery SOC at a preset time interval (for example, 0.001 sec) during constant current charging using the k^{th} reference current Iₖ. The control unit 140 may change from constant current charging using the k^{th} reference current Iₖ to constant voltage charging using the k^{th} reference voltage Vₖ in response to the battery voltage having reached the k^{th} reference voltage Vₖ before the SOC of the battery B reaches the upper limit value Sₖ of the k^{th} reference SOC range ΔSOCₖ. Accordingly, the battery B is charged at constant voltage of the k^{th} reference voltage Vₖ from the time when the battery voltage reaches the k^{th} reference voltage Vₖ to the time when the SOC of the battery B reaches the upper limit value Sₖ of the k^{th} reference SOC range ΔSOCₖ. Referring to the second current profile 220, during constant voltage charging using the k^{th} reference voltage Vₖ, the battery current gradually reduces with the gradually increasing battery voltage.

For example, constant current charging using the second reference current I₂ is performed over the SOC range of S₁ ~ Z₂ [%], and subsequently, constant voltage charging is performed over the SOC range of Z₂ ~ S₂ [%] (second constant voltage charging range) while keeping the battery voltage of the battery B equal to the second reference voltage V₂. Additionally, it can be seen from the second current profile 220 that the battery current gradually reduces from the second reference current I₂ while the battery B is being charged at constant voltage by the second reference voltage V₂.

The control unit 140 may update the charge map including the first current profile 210 of FIG. 2 and the first voltage profile 310 of FIG. 3 based on the battery voltage and the battery current monitored while the charging procedure for at least one of the first to fourth reference SOC ranges ΔOC₁~ΔSOC₄ is being performed in a sequential order.

Specifically, the control unit 140 may determine a k^{th} average current from the time-series (referred to as 'current history') of the battery current monitored over a k constant voltage charging period which is a charging period of the k^{th} constant voltage charging range Zₖ ~ Sₖ. The k^{th} average current may be an average of battery currents sensed repeatedly at a preset time interval for the k^{th} constant voltage charging period. Accordingly, the k^{th} average current is smaller than the k^{th} reference current Iₖ.

Subsequently, the control unit 140 may update the k^{th} reference current Iₖ of the charge map based on the k^{th} average current. The current I₁₁~I₁₄ of the third current profile 230 of FIG. 2 may be the result of updating the reference current I₁~I₄ of the charge map, respectively.

The control unit 140 may update the k^{th} reference current Iₖ to be equal to the k^{th} average current. For example, referring to FIG. 2, where the second reference current I₂ = 120 A, the second average current = 100 A, the second reference current I₂ of 120 A is changed to I₁₂ of 100 A.

Alternatively, the control unit 140 may update the k^{th} reference current Iₖ to be equal to the sum of multiplication of the k^{th} reference current Iₖ and a first weight and multiplication of the k^{th} average current and a second weight. Each of the first weight and the second weight may be a positive number of less than 1, and the sum of the first weight and the second weight may be 1. For example, where the second reference current I₂ = 120 A, the second average current = 100 A, the first weight = 0.4 and the second weight = 0.6, the second reference current I₂ of 120 A may be changed to I₁₂ of 108 A and recorded in the charge map.

Meanwhile, despite not having been performed for each of all the reference SOC ranges ΔOC₁~ΔSOC₄ in a sequential order, the charging procedure according to the above-described battery management method often ends. For example, charging may start before the battery B is fully discharged, or a vehicle user may separate a charging cable from the electric vehicle 1 before constant current charging is changed to constant voltage charging. In this case, it is possible to update the reference current corresponding to some reference SOC ranges having undergone the charging procedure as described above, but it may be impossible to update the reference current corresponding to the remaining reference SOC ranges.

To solve the above-described problem, in case that charging starts when the SOC of the battery B is larger than S₀, or charging ends when the SOC of the battery B is smaller than S₄, the control unit 140 may update the reference current associated with each of the remaining reference SOC ranges based on update information of at least one of the reference SOC ranges ΔSOC₁~ΔSOC₄.

Assume that only the k^{th} reference current Iₖ corresponding to the k^{th} reference SOC range ΔSOCₖ was updated to I₁ₖ according to the above-described battery management method. The control unit 140 may determine a ratio of I₁ₖ to Iₖ, and update each of the remaining reference currents based on the determined ratio. For example, when the second reference current I₂ is updated from 120 A to 100 A, the control unit 140 may update the first reference current I₁, the third reference current I₃ and the fourth reference current I₄ by multiplying each of the first reference current I₁, the third reference current I₃ and the fourth reference current I₄ by 100/120=5/6.

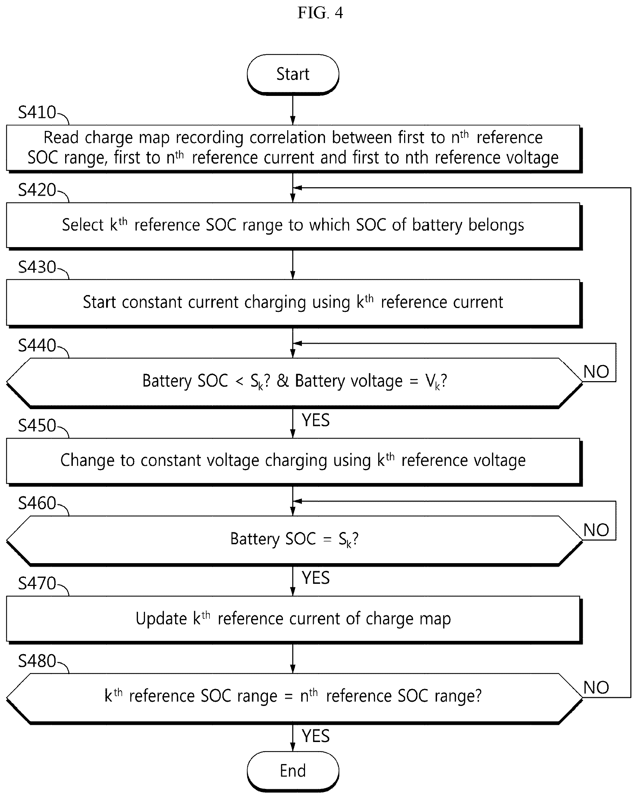

Assume that each of i and j is a natural number, i ≤ j, i is 2 or greater or j is less than n. Only the i^{th} to j^{th} reference currents Iᵢ~Iⱼ corresponding to the i^{th} to j^{th} reference SOC ranges ΔSOCᵢ~ΔSOCⱼ are updated from Iᵢ~Iⱼ to I₁ᵢ~I₁ⱼ according to the battery management method (see FIG. 4), respectively, and the charging procedure may end. Then, the control unit 140 may update each of the remaining reference currents using the following equation. ${I}_{1 x} = {I}_{x} \times \frac{1}{\left(j-i+1\right)} \times {\sum }_{y = i}^{j} \frac{{I}_{1 y}}{{I}_{y}} = {I}_{x} \times {μ}_{avg}$

In the above equation, x is a natural number of n or smaller except i to j, Iₓ is the reference current before update, and I₁ₓ is the updated reference current. µ_{avg} is an average ratio of the i^{th} to j^{th} updated reference currents I₁ᵢ~I₁ⱼ to the i^{th} to j^{th} reference currents Iᵢ~Iⱼ.

In an example, when i=2, j=3, n=4, i₁ = 150 A, i₂ = 120 A, i₁₂ = 100 A, i₃ = 110 A, i₁₃ = 95 A, i₄ = 90 A, i₁₁ = i₁×1/2×{100/120+95/110} A ≒ 127 A, i₁₄ = i₄×1/2×{100/120+95/110} A ≒ 76 A.

FIG. 4 is a flowchart exemplarily showing a battery management method according to a first embodiment of the present disclosure.

Referring to FIGS. 1 to 4, in step S410, the control unit 140 reads a charge map 210, 310 recording a correlation between first to n^{th} reference SOC ranges ΔSOC₁~ΔSOCₙ, first to n^{th} reference currents I₁~Iₙ and first to n^{th} reference voltage V₁~Vₙ from the memory unit 120 in response to a charge start command.

In step S420, the control unit 140 selects a k^{th} reference SOC range ΔSOCₖ to which the SOC of the battery B belongs among the first to n^{th} reference SOC ranges ΔSOC₁~ΔSOCₙ. For example, when the SOC of the battery B is S₁ or more and less than S₂, the second reference SOC range ΔSOC₂ is selected.

In step S430, the control unit 140 starts constant current charging using a k^{th} reference current Iₖ corresponding to the k^{th} reference SOC range ΔSOCₖ.

In step S440, the control unit 140 determines whether the battery voltage reached a k^{th} reference voltage Vₖ corresponding to the k^{th} reference SOC range ΔSOCₖ before the SOC of the battery reached the upper limit value Sₖ of the k^{th} reference SOC range ΔSOCₖ. When a value of the step S440 is "YES", step S450 is performed.

In the step S450, the control unit 140 changes from constant current charging using the k^{th} reference current Iₖ to constant voltage charging using the k^{th} reference voltage Vₖ.

In step S460, the control unit 140 determines whether the SOC of the battery reached the upper limit value Sₖ of the k^{th} reference SOC range ΔSOCₖ. When a value of the step S460 is "YES", step S470 is performed.

In the step S470, the control unit 140 updates the k^{th} reference current Iₖ of the charge map based on a current history of the battery current over a charging period of constant voltage charging using the k^{th} reference voltage Vₖ.

In step S480, the control unit 140 whether the k^{th} reference SOC range ΔSOCₖ is the n^{th} reference SOC range ΔSOCₙ. That is, the control unit 140 determines whether the SOC of the battery B reached the maximum SOC Sₙ of multi-stage constant-current charging defined by the charge map. When the value of the step S480 is "NO", the method returns to the step S420. When the value of the step S480 is "YES", the method of FIG. 4 may end.

For reference, when an update condition is not satisfied, but the charge start command is received, the steps S440~S470 may be omitted from the method of FIG. 4.

The method of FIG. 4 may start in response to the charge start command when the predetermined update condition is satisfied. The update condition is for preventing the unnecessarily frequent updates of the charge map 210, 310. The update condition indicates an increase in the degree of degradation of the battery B over a predetermined level, and may be, for example, an increase in the accumulated capacity of the battery B by at least a first threshold (for example, 100 Ah[ampere-hour]) than the accumulated capacity at the previous update time, an increase in the cycle number of the battery B by at least a second threshold (for example, 50 times) than the cycle number at the previous update time, a reduction in the capacity retention rate of the battery B by at least a third threshold (for example, 5%) than the capacity retention rate at the previous update time, and an increase by at least a threshold time (for example, a month) from the previous update time.

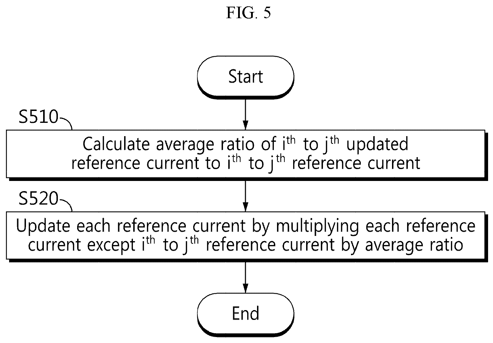

FIG. 5 is a flowchart exemplarily showing a battery management method according to a second embodiment of the present disclosure. When only the i^{th} to j^{th} reference currents Iᵢ~Iⱼ among the first to n^{th} reference currents I₁~Iₙ are updated through the method of FIG. 4, the method of FIG. 5 may be used to update each of the remaining reference currents. That is, the method of FIG. 5 may be performed when the battery B is charged in only some of the entire SOC range of S₀~Sₙ (for example, Z₁~S₃ of FIG. 2) by the method of FIG. 4. As described above, each of i and j is a natural number, i < j, and i is 2 or greater, or j is less than n.

In step S510, the control unit 140 calculates an average ratio of the i^{th} to j^{th} updated reference currents I₁ᵢ~I₁ⱼ to the i^{th} to j^{th} reference currents Iᵢ~Iⱼ (see µ_{avg} of the above equation).

In step S520, the control unit 140 updates each reference current except the i^{th} to j^{th} reference currents Iᵢ~Iⱼ among the first to n^{th} reference currents I₁~Iₙ by multiplying each reference current by the average ratio.

The embodiments of the present disclosure described hereinabove are not implemented only through the apparatus and method, and may be implemented through programs that perform functions corresponding to the configurations of the embodiments of the present disclosure or recording media having the programs recorded thereon, and such implementation may be easily achieved by those skilled in the art from the disclosure of the embodiments previously described.

While the present disclosure has been hereinabove described with regard to a limited number of embodiments and drawings, the present disclosure is not limited thereto and it is obvious to those skilled in the art that various modifications and changes may be made thereto within the technical aspects of the present disclosure and the equivalent scope of the appended claims.

Additionally, as many substitutions, modifications and changes may be made to the present disclosure described hereinabove by those skilled in the art without departing from the technical aspects of the present disclosure, the present disclosure is not limited by the above-described embodiments and the accompanying drawings, and some or all of the embodiments may be selectively combined to allow various modifications.

## Claims

1. A battery management system (100), comprising:
a sensing unit (110) configured to generate a sensing signal indicating a battery voltage and a battery current of a battery; **characterized by** further comprising:
a memory unit (120) configured to store a charge map recording a correlation between first to n^{th} reference state of charge, SOC, ranges, first to n^{th} reference currents and first to n^{th} reference voltages for multi-stage constant-current charging; and
a control unit (140) configured to start constant current charging using a k^{th} reference current corresponding to a k^{th} reference SOC range to which an SOC of the battery belongs among the first to n^{th} reference SOC ranges in response to a charge start command,
wherein the control unit (140) is configured to:
change from the constant current charging to constant voltage charging using a k^{th} reference voltage in response to the battery voltage having reached the k^{th} reference voltage corresponding to the k^{th} reference SOC range before the SOC of the battery reaches an upper limit value of the k^{th} reference SOC range during the constant current charging, and
update the k^{th} reference current of the charge map based on a time-series of the battery current in a charging period of the constant voltage charging in response to the SOC of the battery having reached the upper limit value of the kth reference SOC range during the constant voltage charging,
wherein n is a natural number of 2 or greater, and k is a natural number of n or smaller.

2. The battery management system (100) according to claim 1, wherein the control unit (140) is configured to:
determine an average current in the charging period from the time-series of the battery current, and
update the k^{th} reference current to be equal to the average current.

3. The battery management system (100) according to claim 1, wherein the control unit (140) is configured to:
determine an average current in the charging period from the time-series of the battery current, and
update the k^{th} reference current to be equal to a sum of multiplication of the k^{th} reference current and a first weight and multiplication of the average current and a second weight.

4. The battery management system (100) according to claim 3, wherein each of the first weight and the second weight is a positive number of less than 1, and
a sum of the first weight and the second weight is 1.

5. The battery management system (100) according to claim 1, wherein the control unit (140) is configured to update each remaining reference current except the k^{th} reference current among the first to n^{th} reference currents based on a ratio of the updated k^{th} reference current to the k^{th} reference current.

6. A battery pack (10) comprising the battery management system according to any one of claims 1 to 5.

7. An electric vehicle comprising the battery pack (10) according to claim 6.

8. A battery management method, **characterized by** comprising:
starting constant current charging (S430) using a k^{th} reference current corresponding to a k^{th} reference state of charge, SOC, range to which an SOC of the battery belongs among first to n^{th} reference SOC ranges from a charge map recording a correlation between the first to n^{th} reference SOC ranges, first to n^{th} reference currents and first to n^{th} reference voltages for multi-stage constant-current charging in response to a charge start command;
changing (S450) from the constant current charging to constant voltage charging using a k^{th} reference voltage in response to a battery voltage having reached the k^{th} reference voltage corresponding to the k^{th} reference SOC range before the SOC of the battery reaches an upper limit value of the k^{th} reference SOC range during the constant current charging; and
updating (S470) the k^{th} reference current of the charge map based on a time-series of a battery current in a charging period of the constant voltage charging in response to the SOC of the battery having reached the upper limit value of the kth reference SOC range during the constant voltage charging,
wherein n is a natural number of 2 or greater, and k is a natural number of n or smaller.

9. The battery management method according to claim 8, wherein updating the k^{th} reference current of the charge map comprises:
determining an average current in the charging period from the time-series of the battery current; and
updating the k^{th} reference current to be equal to the average current.

10. The battery management method according to claim 8, further comprising:
updating each remaining reference current except the k^{th} reference current among the first to n^{th} reference currents based on a ratio between the k^{th} reference current and the updated k^{th} reference current.

## Patentansprüche

1. Batterieverwaltungssystem (100), umfassend:
eine Sensoreinheit (110), die ausgebildet ist, um ein Sensorsignal zu erzeugen, das eine Batteriespannung und einen Batteriestrom einer Batterie angibt; **dadurch gekennzeichnet, dass** sie weiter Folgendes umfasst:
eine Speichereinheit (120), die ausgebildet ist, um eine Ladekarte zu speichern, die eine Korrelation zwischen ersten bis n^{ten} Referenzladezustands-, SOC-Bereichen, ersten bis n^{ten} Referenzströmen und ersten bis n^{ten} Referenzspannungen für mehrstufiges Laden mit konstantem Strom aufzeichnet; und
eine Steuereinheit (140), die ausgebildet ist, um Laden mit konstantem Strom unter Verwendung eines k^{ten} Referenzstroms, der einem k^{ten} Referenz-SOC-Bereich entspricht, dem ein SOC der Batterie angehört, unter den ersten bis n^{ten} Referenz-SOC-Bereich als Reaktion auf einen Ladestartbefehl zu starten,
wobei die Steuereinheit (140) zu Folgendem ausgebildet ist:
vom Laden mit konstantem Strom auf Laden mit konstanter Spannung unter Verwendung einer k^{ten} Referenzspannung als Reaktion auf die Batteriespannung, welche die k^{te} Referenzspannung erreicht hat, entsprechend dem k^{ten} Referenz-SOC-Bereich zu wechseln, bevor der SOC der Batterie beim Laden mit konstantem Strom einen oberen Grenzwert des k^{ten} Referenz-SOC-Bereichs erreicht, und
den k^{ten} Referenzstrom der Ladekarte auf der Grundlage einer Zeitreihe des Batteriestroms in einem Ladezeitraum des Ladens mit konstanter Spannung als Reaktion darauf zu aktualisieren, dass der SOC der Batterie beim Laden mit konstanter Spannung den oberen Grenzwert des k-ten Referenz-ROC-Bereichs erreicht hat,
wobei n eine natürliche Zahl von 2 oder mehr ist, und k eine natürliche Zahl von n oder weniger ist.

2. Batterieverwaltungssystem (100) nach Anspruch 1, wobei die Steuereinheit (140) zu Folgendem ausgebildet ist:
einen durchschnittlichen Strom im Ladezeitraum aus der Zeitreihe des Batteriestroms zu bestimmen, und
den k^{ten} Referenzstrom zu aktualisieren, um gleich dem durchschnittlichen Strom zu sein.

3. Batterieverwaltungssystem (100) nach Anspruch 1, wobei die Steuereinheit (140) zu Folgendem ausgebildet ist:
einen durchschnittlichen Strom im Ladezeitraum von der Zeitreihe des Batteriestroms zu bestimmen, und
den k^{ten} Referenzstrom zu aktualisieren, um gleich einer Summe einer Multiplikation des k^{ten} Referenzstroms und einer ersten Gewichtung und Multiplikation des durchschnittlichen Stroms und einer zweiten Gewichtung zu sein.

4. Batterieverwaltungssystem (100) nach Anspruch 3, wobei jede von der ersten Gewichtung und der zweiten Gewichtung eine positive Zahl kleiner als 1 ist, und
eine Summe der ersten Gewichtung und der zweiten Gewichtung 1 ist.

5. Batterieverwaltungssystem (100) nach Anspruch 1, wobei die Steuereinheit (140) ausgebildet ist, um jeden verbleibenden Referenzstrom mit Ausnahme des k^{ten} Referenzstroms unter den ersten bis n^{ten} Referenzströmen auf der Grundlage eines Verhältnisses des aktualisierten k^{ten} Referenzstroms zum k^{ten} Referenzstrom zu aktualisieren.

6. Batteriepack (10), umfassend das Batterieverwaltungssystem nach einem der Ansprüche 1 bis 5.

7. Elektrofahrzeug, umfassend das Batteriepack (10) nach Anspruch 6.

8. Batterieverwaltungsverfahren, **dadurch gekennzeichnet, dass** es Folgendes umfasst:
Starten des Ladens mit konstantem Strom (S430) unter Verwendung eines k^{ten} Referenzstroms entsprechend einem k^{ten} Referenzladezustands-, SOC-Bereich, dem ein SOC der Batterie angehört, unter den ersten bis n^{ten} Referenz-SOC-Bereichen von einer Ladekarte, die eine Korrelation zwischen den ersten bis n^{ten} Referenz-SOC-Bereichen, ersten bis n^{ten} Referenzströmen und ersten bis n^{ten} Referenzspannungen für mehrstufiges Laden mit konstantem Strom aufzeichnet, als Reaktion auf einen Startbefehl;
Wechseln (S450) vom Laden mit konstantem Strom auf Laden mit konstanter Spannung unter Verwendung einer k^{ten} Referenzspannung als Reaktion auf eine Batteriespannung, welche die k^{te} Referenzspannung erreicht hat, entsprechend dem k^{ten} Referenz-SOC-Bereich, bevor der SOC der Batterie beim Laden mit konstantem Strom einen oberen Grenzwert des k^{ten} Referenz-SOC-Bereichs erreicht; und
Aktualisieren (S470) des k^{ten} Referenzstroms der Ladekarte auf der Grundlage einer Zeitreihe eines Batteriestroms in einem Ladezeitraum des Ladens mit konstanter Spannung als Reaktion darauf, dass der SOC der Batterie beim Laden mit konstanter Spannung den oberen Grenzwert des k-ten Referenz-ROC-Bereichs erreicht hat,
wobei n eine natürliche Zahl von 2 oder mehr ist, und k eine natürliche Zahl von n oder weniger ist.

9. Batterieverwaltungsverfahren nach Anspruch 8, wobei Aktualisieren des k^{ten} Referenzstroms der Ladekarte Folgendes umfasst:
Bestimmen eines durchschnittlichen Stroms im Ladezeitraum von der Zeitreihe des Batteriestroms; und
Aktualisieren des k^{ten} Referenzstroms, um gleich dem durchschnittlichen Strom zu sein.

10. Batterieverwaltungsverfahren nach Anspruch 8, weiter umfassend:
Aktualisieren jedes verbleibenden Referenzstroms mit Ausnahme des k^{ten} Referenzstroms unter den ersten bis n^{ten} Referenzströmen auf der Grundlage eines Verhältnisses des k^{ten} Referenzstroms zum aktualisierten k^{ten} Referenzstrom.

## Revendications

1. Système (100) de gestion de batterie, comprenant :
une unité de détection (110), configurée pour générer un signal de détection indiquant une tension de batterie et un courant de batterie d'une batterie ; **caractérisé par** le fait de comprendre en outre :
une unité de mémoire (120), configurée pour stocker une carte de charge enregistrant une corrélation entre des premières à n^{ièmes} plages d'état de charge, SOC, de référence, des premiers à n^{ièmes} courants de référence et des premières à n^{ièmes} tensions de référence pour une charge à courant constant à plusieurs étages ; et
une unité de commande (140), configurée pour débuter une charge à courant constant utilisant un k^{ième} courant de référence correspondant à une k^{ième} plage de SOC de référence à laquelle appartient un SOC de la batterie parmi les premières à n^{ièmes} plages de SOC de référence en réponse à une commande de début de charge,
dans lequel l'unité de commande (140) est configurée pour :
passer de la charge à courant constant à une charge à tension constante utilisant une k^{ième} tension de référence en réponse au fait que la tension de batterie a atteint la k^{ième} tension de référence correspondant à la k^{ième} plage de SOC de référence avant que le SOC de la batterie n'atteigne une valeur limite supérieure de la k^{ième} plage de SOC de référence pendant la charge à courant constant, et
mettre à jour le k^{ième} courant de référence de la carte de charge sur la base d'une série temporelle du courant de batterie dans une période de charge de la charge à tension constante en réponse au fait que le SOC de la batterie a atteint la valeur limite supérieure de la k-ième plage de SOC de référence pendant la charge à tension constante,
dans lequel n est un nombre naturel supérieur ou égal à 2, et k est un nombre naturel inférieur ou égal à n.

2. Système (100) de gestion de batterie selon la revendication 1, dans lequel l'unité de commande (140) est configurée pour :
déterminer un courant moyen dans la période de charge à partir de la série temporelle du courant de batterie, et
mettre à jour le k^{ième} courant de référence de telle sorte qu'il soit égal au courant moyen.

3. Système (100) de gestion de batterie selon la revendication 1, dans lequel l'unité de commande (140) est configurée pour :
déterminer un courant moyen dans la période de charge à partir de la série temporelle du courant de batterie, et
mettre à jour le k^{ième} courant de référence de telle sorte qu'il soit égal à une somme de la multiplication du k^{ième} courant de référence et d'un premier coefficient de pondération et de la multiplication du courant moyen et d'un second coefficient de pondération.

4. Système (100) de gestion de batterie selon la revendication 3, dans lequel chacun parmi le premier coefficient de pondération et le second coefficient de pondération est un nombre positif inférieur à 1, et
la somme du premier coefficient de pondération et du second coefficient de pondération est égale à 1.

5. Système (100) de gestion de batterie selon la revendication 1, dans lequel l'unité de commande (140) est configurée pour mettre à jour chaque courant de référence restant à l'exception du k^{ième} courant de référence parmi les premiers à n^{ièmes} courants de référence sur la base du rapport du k^{ième} courant de référence mis à jour au k^{ième} courant de référence.

6. Bloc-batterie (10) comprenant le système de gestion de batterie selon l'une quelconque des revendications 1 à 5.

7. Véhicule électrique comprenant le bloc-batterie (10) selon la revendication 6.

8. Procédé de gestion de batterie, **caractérisé en ce qu'**il comprend :
le fait de débuter une charge à courant constant (S430) en utilisant un k^{ième} courant de référence correspondant à une k^{ième} plage d'état de charge, SOC, de référence à laquelle appartient un SOC de la batterie parmi les premières à n^{ièmes} plages d'état de charge, SOC, de référence à partir d'une carte de charge enregistrant une corrélation entre les premières à n^{ièmes} plages d'état de charge, SOC, de référence, les premiers à n^{ièmes} courants de référence et les premières à n^{ièmes} tensions de référence pour une charge à courant constant à plusieurs étages en réponse à une commande de début de charge ;
le fait de passer (S450) de la charge à courant constant à une charge à tension constante utilisant une k^{ième} tension de référence en réponse au fait que la tension de batterie a atteint la k^{ième} tension de référence correspondant à la k^{ième} plage de SOC de référence avant que le SOC de la batterie n'atteigne une valeur limite supérieure de la k^{ième} plage de SOC de référence pendant la charge à courant constant ; et
le fait de mettre à jour (S470) le k^{ième} courant de référence de la carte de charge sur la base d'une série temporelle d'un courant de batterie dans une période de charge de la charge à tension constante en réponse au fait que le SOC de la batterie a atteint la valeur limite supérieure de la k-ième plage de SOC de référence pendant la charge à tension constante,
dans lequel n est un nombre naturel supérieur ou égal à 2, et k est un nombre naturel inférieur ou égal à n.

9. Procédé de gestion de batterie selon la revendication 8, dans lequel la mise à jour du k^{ième} courant de référence de la carte de charge comprend :
le fait de déterminer un courant moyen dans la période de charge à partir de la série temporelle du courant de batterie ; et
le fait de mettre à jour le k^{ième} courant de référence de telle sorte qu'il soit égal au courant moyen.

10. Procédé de gestion de batterie selon la revendication 8, comprenant en outre :
le fait de mettre à jour chaque courant de référence restant à l'exception du k^{ième} courant de référence parmi les premiers à n^{ièmes} courants de référence sur la base d'un rapport entre le k^{ième} courant de référence et le k^{ième} courant de référence mis à jour.
